# EUROPEAN PATENT APPLICATION

(11) **EP 2 720 258 A1**
(43) Date of publication of application: **16.04.2014**
(21) Application number: 12188398.7
(22) Date of filing: 12.10.2012
(51) Int. Cl.: H01L 21/677, H01L 21/673

(54) **Wafer handling system**

(71) Applicant: Meyer Burger AG, 3645 GWATT (Thun) (CH)
(72) Inventor: Wenger, Markus, 3752 Wimmis (CH); Schnyder, Matthias, 3604 Thun (CH); Heiniger, Christoph, 3053 Münchenbuchsee (CH)
(74) Representative: Patentbüro Paul Rosenich AG

(57) **Abstract**

The invention relates to a wafer handling system (1) for handling a plurality of essentially parallel aligned wafers (2), the system comprising:
- a wafer interacting part (10) comprising wafer interacting means for acting upon the plurality of wafers (2), and
- at least one wafer receiving part (11, 12) for receiving the plurality of wafers (2), characterized in that

the wafer interacting part (10) and the at least one wafer receiving part (11) are dimensioned relative to each other such that one of the wafer interacting part (10) and the wafer receiving part (11, 12) may inserted into the other of the wafer interacting part (10) and the wafer receiving part (11, 12).

## Description

The invention refers to wafer handling system for handling a plurality of essentially parallel aligned wafers, the system comprising:
- a wafer interacting part comprising wafer interacting means for acting upon the plurality of wafers, and
- at least one wafer receiving part for receiving the plurality of wafers. The invention also relates to a wafer handling method.

Wafers made of poly-crystalline or mono-crystalline semiconductor material, e.g. silicon or other materials such as sapphire, are cut from a block (also called brick or ingot) in a wire saw. Wafers are subjected to multiple wafer processing steps such as cleaning, de-gluing, separating, texturization, etc. before the may be used in semiconductor industry, e.g. in electronic parts or solar cells.

In order to avoid damages to the wafers during transport it is known from prior art to use containers for receiving the wafer block (plurality of parallel aligned wafers, which are more or less still in the position they were during the cut or at least they are in the same relative order to each other). Containers are also used to clean or otherwise treat the wafers.

Usually the ingot or brick to be cut is glued to a beam (also called sacrificial substrate), which in turn is attached to a fixture attachment during the cutting step. The fixture attachment may be horizontally inserted between two guide rails of a wire saw or be otherwise positioned in the latter. The guide rails are only used for inserting the workpiece into the machine. As soon as the workpiece is in position, clamps hold the fixture attachment during cutting. When the cutting process is finished, the wafer block (arrangement of a plurality of more or less parallel wafers) may be slid out of the cutting device, while the fixture attachment is supported by the two guide rails.

Due to the fact, that the load is pretty heavy, the relative motion of the guide rails, the fixture attachment and the dirt (slurry or (contaminated) cutting fluid) produces friction that is irregular and pretty hard to overcome. Moreover, when moving the block into and more importantly out of the cutting device or during transportation, the wafers wobble (e.g. slip-stick effect). In the case of the inward movement this does not constitute a problem, since the block has not been cut yet. However, when removing said wafer block comprising a plurality of extremely thin and fragile wafers, the so called slip-stick effect causes damages to the wafers. The individual wafers tilt easily about the axis formed by the thin attachment zone on the beam or the fixture attachment, respectively. This causes adjacent wafers to touch each other. When the wafers however touch each other they may be damaged or stick to each other in an undesirable way (makes cleaning harder). Hence the slip-stick effect causes yield loss, resulting in higher costs per wafer.

Wafer receiving boxes are also used for removing wafers or wafer blocks from the wire saw but also for transporting the wafers to the next processing station. They may even be inserted in the next processing station that than may handle the wafers or bricks automatically.

Wafer carriers for wafers for solar cells are known from the state of the art. They often have (movable) means for holding the wafers, e.g. CN201788957U, DE102005028112A, DE102006052908A, DE102008060012 A1, DE102008060014 A1, DE102008062123 A1, DE102008060012 A1, JP10181880 A and W02008106913 A2.

JP5220731A discloses a wafer cutting and separating method, wherein the cutting wire of a wire saw cuts in a horizontal manner when it has reached the beam. The separated wafers are received by wafer receiving box.

JP7153724A discloses that the wafers cut from an ingot are received by a cassette after the step of cutting. The distance between the wire guide rollers of the corresponding wire saw is very large such that the cutting quality is adversely effected.

WO2012031900A1 discloses a loading device which is used to move the work piece holder with attached brick and wafer brick in and out of the wire saw, respectively.

Production of wafers requires several processing steps. Careful handling of the wafers, e.g. holding, displacing, de-gluing, transporting, cleaning and separating the wafers, throughout the production is essential for a high wafer's quality and a high yield. Wafer carriers or wafer receiving containers according to prior art are optimized for a certain wafer processing station but fail to comply with the requirements of a different wafer processing stations. Different geometrical dimensions and different functionalities of wafer processing stations, leads to a suboptimal wafer handling, since known wafer carriers are not adapted to multiple wafer processing stations.

For example, the space between wire guide rollers of a wire saw is limited. The functionality of the wafer carrier therefore has to be limited to what is needed for the sawing process, i.e. receiving the wafers during sawing. Adding other functionality that may be desirable later would cost additional space, impairing the design of the wire saw, where e.g. the wire guide rollers need to be as close together as possible. Such wafer carrier would require a lot of space due to their geometric design such that the distance between two wire guide rollers of a wire saw has to be large enough to receive the wafer receiving box in between them. However, in order to keep the quality of the wafers as high as possible it has been found that the wire sections extending between the wire guide rollers should be as short as possible. In prior art wafer cutting systems in which the wafers are received during the cutting process in the wire saw (in-situ) the quality of the wafers is diminished by the fact that the distance between two wire guide rollers is too large having an adverse effect on holding the wire web in optimal position and tension.

The object of the present invention is to overcome these problems and to provide a wafer handling system and method allowing a careful and reliable handling of wafers during their production. The wafer handling system should be flexible and adaptable to the different needs given by different wafer processing steps and stations. The wafer handling system should provide different functionalities without the need to complicatedly adapt the individual wafer processing stations. Furthermore, the wafer handling system should be adaptable to situations where space is crucial, without departing from the functionalities required in different processing stations. Wafer production should become more straightforward and the handling of the wafers easier. The individual processing steps should become more time- and cost-effective and the quality of produced wafers should be increased.

This object is achieved by a wafer handling system mentioned above wherein the wafer interacting part and the at least one wafer receiving part are dimensioned relative to each other such that one of the wafer interacting part and the wafer receiving part may inserted into the other of the wafer interacting part the wafer receiving part.

The term "inserted" includes the possibility, that the interacting part and the wafer receiving part have cooperating surfaces for engaging each other in the inserted state. In the inserted state one part (e.g. wafer interacting part) rests with its cooperating surface on the cooperating surface of other part (e.g. wafer receiving part).

Preferably, engaging means of one part cooperate with an abutting member of the other part. Even more preferably, the cooperating surfaces extend at least partially in horizontal direction so the when the parts are inserted into one another, the engaging means of the one part abuts on the abutting member of the other part in vertical direction, the cooperating surfaces of the two parts extending in horizontal direction during normal usage.

Due to the fact that the wafer interacting part and the wafer receiving part are insertable into one another (meaning that in a first embodiment the one may be inserted into the other and in a second embodiment vice versa), wafer handling is provided with more options, i.e. different functionalities may be combined at one location. The wafer receiving part has the functionality of receiving wafers. An additional functionality, i.e. the functionality of the wafer interacting part, can be added at the same location by a relative insertion of the wafer interacting part and wafer receiving part. This allows a space-saving design and a very careful handling of the wafers.

The invention covers both possibilities: In one embodiment the wafer interacting part is insertable into the wafer receiving part and in a other embodiment the wafer receiving part is insertable into the wafer interacting part. Further, the term "insertable" describes the way the parts are put together. Once inserted, members of each part may extend through openings in the other part as to extend to the other side of it.

The wafer receiving part has the functionality of receiving the wafers but can have additional functionalities, such as the functionality of actively interacting with the wafers. The wafer interacting part has the functionality of acting upon the wafers but can have additional functionalities, such as the functionality of receiving the wafers in an enclosure, the functionality of pulling the wafers from the beam, the functionality of containing and/or conducting fluid, e.g. for cleaning (cleaning nozzles), etc..

Preferably, the wafer interacting part is designed such that the plurality wafers may be also received by the wafer interacting part, i.e. the plurality of wafers are at least partially enclosed or surrounded by the interacting part.

The wafer interacting means is independently of the beam to which the wafers are attached immediately after the cutting step. The wafer interacting means is designed such, that it acts laterally on the plurality of wafers. The wafer interacting means may comprise e.g. a holding mechanism laterally engaging the plurality of wafers. The holding mechanism may comprise one or more movable holding members which are movable towards the lateral face of the plurality of wafers when received by the wafer interacting means.

The wafer interacting means may be asymmetrical to the plurality wafers when being received by the wafer interacting part. Moreover, the wafer interacting means on one side of the plurality of wafers may differ from the wafer interacting means on the other side of the wafers.

The wafer interacting means may be selected from the group consisting of a holding mechanism for holding the wafers, a detaching means for detaching the wafers from the beam, a fluid application means for applying a fluid to the wafers and/or to the beam, fluid flow generating means for generating a fluid flow, and a displacing mechanism for displacing the wafers relative to the walls of the at least one wafer receiving part, an energy source for transferring energy to the wafers, e.g. a heat source or an electromagnetic radiation source.

Preferably, the wafer handling system comprises at least two wafer receiving parts for receiving the plurality of wafers, and wherein the wafer interacting part and the first wafer receiving part are insertable into one another, and wherein the wafer interacting part and the second wafer receiving part are insertable into one another, wherein preferably the first wafer receiving part and the second wafer receiving part have different functionality.

This allows to use the same wafer interacting part with two wafer receiving parts. The two wafer receiving parts may be adapted to different requirements of different processing steps. The wafer receiving parts are individually optimized for their use and may have different functionalities which are needed in that certain processing step. In such a way the functionalities of the interacting part can be delimited, since additional functionalities are provided by the wafer receiving parts.

It has to be mentioned that different functionalities may already exist, if there are e.g. different kinds of holding means.

Preferably, the wafer interacting part may be inserted into the at least one wafer receiving part. When the wafer interacting part carries the plurality of wafers, e.g. by holding means laterally engaging the wafers, the wafer receiving part receives both, the wafer interacting part and the plurality of wafers.

Preferably, the at least one wafer receiving part has on its upper side (the side that is on top e.g. during cutting) an opening adapted for receiving the plurality of wafers. The wafers may be moved into the wafer receiving part from above. This may be done, for example, by means of the wafer interacting part which holds the plurality of wafers and is inserted into the wafer receiving part. Preferably, the handling is performed along a vertical direction, wherein the wafer interacting part and the at least one wafer receiving part may be moved into one another along that vertical direction.

Preferably, the at least one wafer receiving part is a container enclosing a wafer receiving volume, wherein preferably the container is a fluid reservoir adapted to contain fluid in the wafer receiving volume. In this embodiment the wafer receiving part has the functionality of protecting the wafers, since the wafers are separated from outside by side walls of the wafer receiving part. In the case of a fluid reservoir the wafers may be held immersed in a fluid, e.g. for cleaning and/or cooling purposes. The reservoir may comprise any of: at least one inlet for introducing fluid, at least one outlet for controlling the fluid level in the reservoir, at least one fluid current controlling means or any combination thereof.

Preferably, the at least one wafer receiving part is integral part of a wafer processing station, wherein preferably the wafer processing station is selected from the group consisting of a wire saw, a wafer pre-cleaning station, a wafer cleaning station, a wafer de-gluing station for de-gluing the wafers from the beam or removing glue from the wafers, a wafer separating station, a wafer texturization station for texturizing the surface of the wafers or any combination thereof. Such an embodiment becomes possible since the interacting part having individual functionality communicates with the corresponding wafer receiving part of a corresponding wafer processing station. The functionalities of the wafer receiving part and the wafer interacting part complement one another.

Preferably, the wafer interacting means of the wafer interacting part comprises a holding mechanism for holding the plurality of wafers, wherein preferably the holding mechanism may be set in a releasing state and in a holding state. The wafers are laterally engaged by (e.g. opposing) holding members and thus fixed (stable holding state) during their transport towards or from a wafer receiving part. The releasing and holding state are preferably stable states. Moreover, once in that state, the wafer interacting part may be manipulated (e.g. transported) freely without having to actively keep the holding means in that state.

The holding part has (movable) means for holding the wafers. Preferably, these means engage the wafers after cutting has been completed inside the wire saw, even more preferred between the wire guide rollers of a wire saw. They may be also used for de-gluing: dissolving the glue and removing (tearing) the wafers of the beam.

Preferably, the wafer interacting part comprises a base to which the wafer interacting means is mounted, the base defining the position of the wafer interacting means relative to the wafer receiving part when the wafer interacting part and the wafer receiving part are inserted into one another. In the inserted state the base engages or contacts the wafer receiving part, e.g. rests on a part of it. The term 'base' has to be understood as a (mounting) base for the interacting means. The base may be a frame, a support, a platform, a container, etc..

Preferably, the base is built from a framework, wherein preferably the framework has the contour of a cuboid. A framework is a robust but space-saving embodiment.

Preferably, the holding mechanism of the wafer interacting part comprises holding members, which preferably have longitudinal shape, wherein at least one holding member is movable towards the plurality of wafers. The longitudinal holding members arranged on opposing sides may reliably engage the wafer block along its entire length. It is possible that only the holding member on one side of the wafer block may move towards it, the holding member on the other side of the wafer block being static.

Preferably, the holding members are movable from opposite sides towards the plurality of wafers when being received by the wafer interacting part. The parallel arranged holding members move towards each other when moving into the holding state.

Preferably, the longitudinal holding members comprise a brush and/or elastic elements.

Preferably, the at least one wafer receiving part comprises at least one actuator, which cooperates with the wafer interacting means of the wafer interacting part when the wafer interacting part and the wafer receiving part are inserted into one another. In this embodiment the drive for the wafer interacting means is provided at the wafer receiving part. This makes the wafer interacting part more lightweight and its transport much more easier.

Preferably, the actuator acts upon a holding mechanism as to bring the holding mechanism into the release state and/or into the holding state. Holding and releasing state are controlled by the actuator of the wafer receiving part. This prevents that a change from the holding state to the releasing state of the holding mechanism takes place during transport or storage of the wafer interacting part outside the wafer receiving part.

Preferably, the actuator is a pneumatic muscle which is contracted when pressure is applied to it. This allows a space saving design and simple construction.

Preferably, the holding mechanism comprises a guidance element which is movably mounted on a base of the wafer interacting part and cooperates with the ends of the longitudinal holding members wherein a movement of the guidance element relative to the base brings the holding members into the release state and/or the holding state. The holding members are movable with respect to the base. The end of the holding members are guided in the guidance element, e.g. in a slotted guide. A movement of the guidance element relative to the base causes the holding members to move into the release state and/or the holding state. A synchronous movement of the holding members can be easily achieved.

Preferably, an actuation of the actuator causes the base of the wafer interacting part to be lifted relative to the guidance element which in the inserted state of the wafer interacting part and the at least one wafer receiving part is fixed relative to the wafer receiving part. A relative motion between base and guidance element is realized in an uncomplicated manner.

Preferably, the wafer receiving part comprises in its bottom region a movable plate wherein in the inserted state the base of the wafer interacting means rests on that plate, and wherein the wafer receiving part comprises a stop element fixing the guidance element of the wafer interacting part in the inserted state, and wherein the actuator connects the plate and the stop element as to change the distance between them.

Preferably, the holding mechanism is a bi-stable mechanism, the release state being a stable state and the holding state being a stable state. Actuation is only necessary when changing the state. This saves energy and makes the holding mechanism independent of any actuator, which is preferred during transport or storage.

Preferably, the at least one wafer receiving part comprises at least one wafer interacting means for acting upon the plurality of wafers when being received in the wafer receiving part, wherein preferably the wafer interacting means is selected from the group consisting of a holding mechanism for holding the wafers, a detaching means for detaching the wafers from the beam, a fluid application means for applying a fluid to the wafers and/or to the beam, fluid flow generating means for generating a fluid flow, and a displacing mechanism for displacing the wafers relative to the walls of the at least one wafer receiving part, an energy source for transferring energy to the wafers, e.g. a heat source or an electromagnetic radiation source. The functionality of the wafer receiving part can be extended by wafer interacting means.

Preferably, the wafer receiving part or the wafer interacting part comprises a locking mechanism which automatically locks the wafer interacting part with the wafer receiving part when the wafer interacting part and the wafer receiving part are inserted into one another.

Preferably, the wafer handling system comprises a lifting device for engaging and removing the wafer interacting part from the wafer receiving part, wherein preferably the lifting device has a de-locking means for de-locking a locking mechanism between holding part and wafer receiving part and at least one gripper arm for gripping the wafer interacting part. The lifting device advantageously incorporates two functions: de-locking and lifting the wafer interacting part from the wafer receiving part.

Preferably, the de-locking means is formed from at least straight bar (or pin) the end of which cooperating with the locking mechanism between wafer interacting part and wafer receiving part. De-locking may be performed by a simple straight movement of the lifting device relative to the wafer interacting part.

Preferably, the gripper arm is a pivotable lever. This allows a gripping movement which is easy to handle.

Preferably the lifting device has four de-locking means and four gripper arms which are arranged on the edges of a rectangle. This allows a uniform force distribution and a careful wafer handling.

With a locking mechanism the parts can be fixed relative to each other. As stated above, the wafer interacting part may be fixed in the wafer receiving part. Preferably, the locking mechanism disengages automatically when removing the wafer interacting part from the wafer receiving part. This may be done by a lifting device that lifts the wafer interacting part out of the wafer receiving part. In an embodiment the wafer interacting part is the inner part and the wafer receiving part the outer part enclosing the wafer interacting part. However, a converse embodiment would be possible as well.

The de-locking means in form of four pins may penetrate four holes. Below these holes, (metal) parts with identical holes are present; the holes not being aligned at first. They become aligned by a tapered front side of the pin, thus setting the inner part (e.g. two vertical rectangles) free. The gripper arms engage the inner part of the wafer interacting part for lifting it.

The object of the invention is also achieved by a wafer handling method for handling a plurality of essentially parallel aligned wafers, the method comprising the steps of:
- holding the plurality of wafers in a first wafer processing station by means of the wafer interacting part during and/or subsequent to a first processing step, the wafer interacting part and a first wafer receiving part being inserted into one another,
- removing the wafer interacting part together with the plurality of wafers from the first wafer receiving part,
- moving the wafer interacting part holding the plurality of wafers to a second wafer processing station,
- inserting the wafer interacting part and a second wafer receiving part into one another, prior or subsequent to the step of moving the wafer interacting part holding the plurality of wafers to a second wafer processing station,
- performing in the second wafer processing station a second wafer processing step.

The step of moving the wafer interacting part with the plurality of wafers to a second wafer processing station and the step of inserting the wafer interacting part and a second wafer receiving part into one another can be interchanged.

The wafers may be transported in the wafer interacting part alone or together with an (outer) wafer receiving part.

The same wafer interacting part can be used in a first processing station, preferably cooperating with a first (outer) wafer receiving part (that may be part of the first station) and in a next step used in a second processing station cooperating with a second (outer) wafer receiving part (that may be part of that second station).

A preferred embodiment refers to a system for holding wafers during treatment, the system comprising a wafer interacting part having a holding mechanism and a first and a second (outer) wafer receiving part, each of the wafer receiving parts being also able to receive the wafer interacting part, the wafer interacting part being capable of holding the plurality of wafers and the first and the second (outer) wafer receiving parts having additional functionality such as a liquid containing, holding wafers, de-gluing capability wherein the first and second wafer receiving part being different from each other to fulfill different functionality.

Preferably, the wafer receiving part is the outer part of the wafer handling system dimensioned such that it may accommodate the wafer interacting part. That outer part may have additional functionality for processing the wafers (second holding means, fluid containing functionality, fluid flow inducing/supporting means).

In a preferred application the wafers are retrieved from between the wire guide rollers by means of the inventive system.

The wafer interacting part has then movable holding members for engaging the wafers. Preferably, the wafers have been de-glued inside the wire saw. The other option, where the beam has been split may be of interest as well. For holding the detached (de-glued or beam-split) wafers, the holding mechanism of the wafer interacting part must engage the wafers directly or the split beam, not the complete beam assembly or any members attached thereto. The holding mechanism engages the wafers directly or holds the wafers so that their relative position is fixed.

The wafer interacting part may in fact be located outside of the wafer receiving part, the wafer receiving part being positioned between the wafer interacting part and the plurality of wafers (except for where the wafers are held) and thus performing its function.

The wafer interacting part can be adapted to situations where space is crucial. The (outer) wafer receiving part can be adapted to suit the needs where space is not as limited. Using one wafer interacting part in two or more outer parts in multiple processing stations, the two or more outer parts possibly having different functionality, requires in all stations only the space for the functionality then used, not all at once.

For a wire saw: Since the outer part not necessarily has to fit between the wire guide rollers, it can be much bigger, allowing e.g. the wafer interacting means to be placed without compromise. In such a case the wafer interacting part may be adapted to remove the wafers from between the wire guide rollers.

An outer part may be a carrier that can be used to move the wafers around. It may collect fluid coming from the holding parts that was inside the wire saw during cutting.

An outer part may be part of a machine such as a wire saw, pre-cleaning station, de-gluing station, separation station, final cleaning, and texturization station.

An outer part may contain active means such as holding means (possible differing from those of the wafer interacting part), cleaning means, and de-gluing means. Preferably, these means are suitable for or part of the next station the wafers are treated in.

In a preferred embodiment the wafers are de-glued and pre-cleaned in the wire saw. The next step is the singulation. It was found that in the process of cutting, de-gluing and transporting, the wafers are preferably held with elastic members of the holding mechanism. They keep the wafers parallel and can help to pull the wafers from the beam during de-gluing. This way of holding does not work for singulation though. Singulation may be done by a vertical conveyor belt. The wafers are sucked to that belt by openings in the belt and transported in upward direction.

The elastic members hold the wafers too firmly so that the friction with the belt is not enough to move the wafers (without damaging them). Ideally the wafers are at this stage held by brushes: they keep the distance between the wafers, while allowing them to move vertically.

The outer part may have brush-like holding means that hold the wafers during separation. Note that the elastic member from the holding part is now disengaged.

The outer part may be attached to a wafer processing station like a drawer. This is as such known from application W02012031900.

The wafers may be moved in the wafer interacting means from a first outer part to a second outer part. The first and second outer parts, preferably, are not identical, each having special functions for the processing station they are used in.

In a wire saw, the wafer interacting part and the wafer receiving part may be placed between the wire guide rollers during cutting, preferably engaging the wafers after the cut is completed. The wafer interacting part may be also used for de-gluing. The holding mechanism or a displacement mechanism engages the wafers and pulls them from the beam once the glue is soft enough.

Further embodiments of the invention are indicated in the figures and in the dependent claims. The list of reference marks forms part of the disclosure. The invention will now be explained in detail by the drawings. In the drawings:
Fig. 1 shows a wire saw for cutting a plurality of wafers from an ingot with a wafer handling system,
Fig. 2 shows the wafer interacting part of the wafer handling system,
Fig. 3 shows the front of the wafer interacting part in detail,
Fig. 4 shows the wafer interacting part being inserted in a wafer receiving part,
Fig. 5 shows the wafer interacting part being inserted in a wafer receiving part, with actuators being in the actuated state forcing holding members in the wafer holding state,
Fig. 6 shows a wafer handling system with a lifting device,
Fig. 7 shows the gripping action of the lifting device, the gripper engaging a recess of the wafer interacting part,
Fig. 8 shows the locking mechanism of the wafer receiving part as being de-locked by the de-locking means of the lifting device,
Fig. 9 shows a wire saw with an inventive wafer handling system,
Fig. 10 shows an embodiment of the wafer handling system,
Fig. 11 shows a wafer processing line comprising a plurality of wafer processing stations,
Fig. 12 shows in a top view a wafer interacting part being inserted in a wafer receiving part,
Fig. 13 shows an embodiment of the wafer handling system, the wafer receiving part comprising a fluid application means for applying a fluid to the wafers,
Fig. 14 shows an embodiment of the wafer handling system, the wafer receiving part comprising a displacing mechanism for displacing wafers relative to walls of the wafer receiving part.

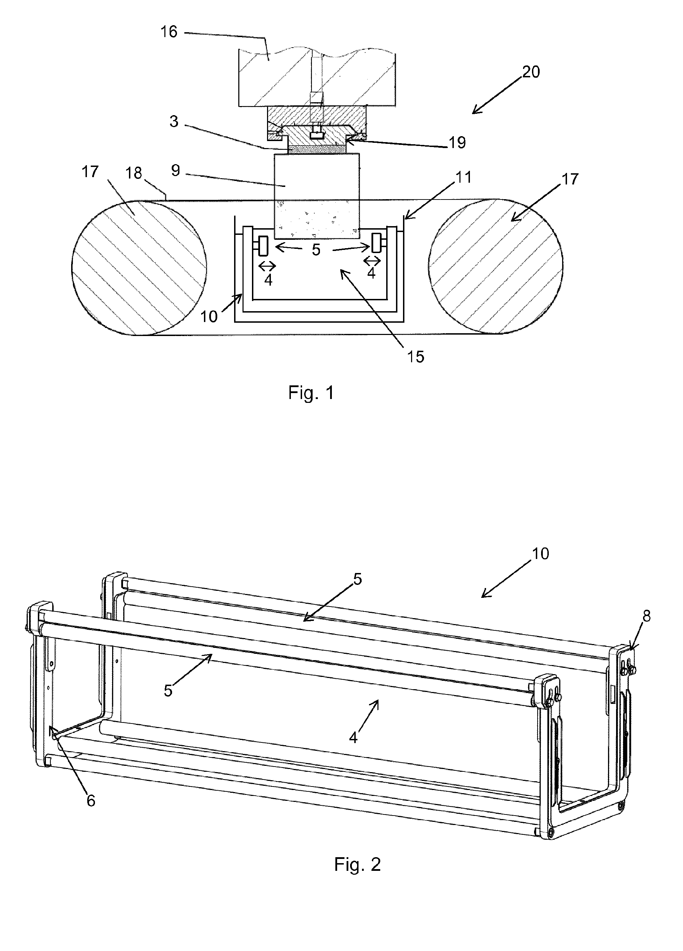

Fig. 1 shows a wire saw 20 for cutting a plurality of (e.g. silicon or sapphire) wafers from an ingot 9 (also called brick or core). The wire saw 2 comprises a support base 16 for positioning ingot 9 with respect to a wire web 18 which is formed by cutting wire. Ingot 9 is glued to a beam 3 (also called sacrificial substrate), which in turn is attached to a fixture attachment 19 usually made of metal. The beam 3 is mounted to the fixture attachment 19 which in turn is detachably mounted to the support base 16 of the wire saw 2. Wire saw 20 further comprises wire guide rollers 17 for forming a field of cutting wire, i.e. wire web 18.

After all cuts for separating the wafers 2 have been made (all wafers are cut in parallel), the wafers 2 are still attached to the beam 3 giving the wafer block a comb-like structure.

During the cutting process, the ingot 9 is pushed through the wire web 18, causing the cutting wire to bend downwards (not shown). Because of this bow of the cutting wire, the top edges of the ingot 9 are cut before the middle part of the ingot 9 is completely cut. It is the purpose of the sacrificial substrate or beam 3 to keep the fixture attachment 19 at a distance of the ingot 9, so that the fixture attachment 19 is not cut. The beam 3 - which is relatively inexpensive - is replaced after each cut.

Once the wafers have been cut, they have to be cleaned and separated from the beam 3. Ideally, the wafers 2 are aligned in parallel with a constant spacing between the individual wafers. However, the wafers 2 are very thin and easily damaged. One can imagine, that if the fixture attachment 19 is tilted or pushed, the wafers 2 move sideward and stick to each other due to the fluid on their respective surfaces.

After the ingot 9 has been cut, the wafers 2 are dirty from the slurry or cutting fluid and the silicon particles that are cut off (swarf). If the wafers 2 are left to dry, the swarf gets stuck to the wafers are very hard to remove. Also the wafers 2 become stains that are not allowable. For both reasons, wafers should be cleaned right after they have been cut, not allowing them to dry while dirty.

There are different possibilities of how to further process the wafers 2 after the cutting step. Usually, the plurality of wafers 2 is removed from the wire saw 20 in form of that wafer block. It is possible to perform a processing step inside the wire saw 20, e.g. a pre-cleaning step or a step of de-gluing the wafers 2 from the beam 3. However, these steps could be also performed outside the wire saw 20 in a separate processing station.

The invention relates to a wafer handling system for handling the wafers during and between individual processing steps. Particularly, the handling relates to (but is not restricted to) transport, storage, holding, wetting and/or displacing the wafers. It is not necessary that the wafers are handled actively between certain steps. Moreover, they may just be left as they are, which is beneficial because they are less likely to be damaged and no operator or handling system is needed.

Fig. 1 shows a wafer handling system 1 according to the invention. The system 1 comprises a wafer receiving part 11 which in the present embodiment is a container. The wafer receiving part 11 encloses a wafer receiving volume 15 for accommodating the plurality of wafers. The wafer receiving part 11 has on its upper side an opening 13 which is adapted for receiving the plurality of wafers 2 from above.

As can be seen from Fig. 1 the wafer receiving part 11 contains fluid and acts as a fluid reservoir. The wafers 2 are immersed in the fluid immediately after the cutting step. This enables the system to keep the wafers 2 wet during transport and/or subsequent processing steps.

The wafer handling system 1 further comprises a wafer interacting part 10 comprising wafer interacting means for acting upon the plurality of wafers 2. In the embodiment of Fig. 1 the interacting means comprises a holding mechanism 4 for holding the plurality of wafers 2. The holding mechanism 4 may be set in a releasing state and in a holding state (indicated by the double arrows in Fig. 1). The holding mechanism 4 and its actuation is described in detail in Fig. 2, 3 and 4.

The wafer interacting part 10 is removably inserted into the wafer receiving part 11. The wafer receiving part 11 is dimensioned such that is may receive the wafers 2 and the wafer interacting part 10 through opening 13 on its top side. The interacting part 10 is removable from the wafer receiving part 11 and thus transportable to a further wafer processing station. However, it would be also possible to transport the plurality of wafers 2 by means of the wafer receiving part 11 or a second wafer receiving part (not shown) and the wafer interacting part 10 which then is still inserted in that wafer receiving part 11.

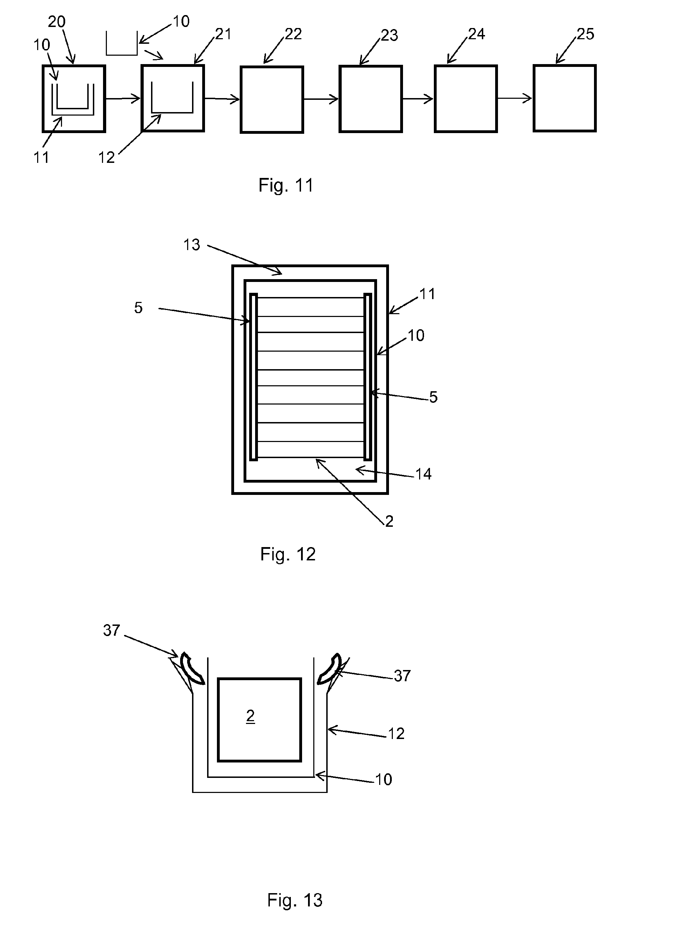

Fig. 12 shows the in a top view a wafer interacting part 10 being inserted in a wafer receiving part 11. The wafer interacting part 10 has an opening 14 for receiving the wafers 2 and the wafer receiving part 11 has an opening 13 for receiving the wafer interacting part 10 and the wafers 2.

Fig. 2 shows a preferred embodiment of the wafer interacting part 10 comprising a base 6, e.g. in form of a frame, to which the holding mechanism 4 is mounted. The base 6 defines the position of the holding mechanism 4 relative to the wafer receiving part 11 when the wafer interacting part 10 and the wafer receiving part 11 are inserted into one another. In the present embodiment base 6 is built from a framework, which has the contour of a cuboid.

The holding mechanism 4 of the wafer interacting part 10 comprises longitudinal holding members 5, which are movable from opposite sides towards the plurality of wafers 2 when being received by the wafer interacting part 10. In the holding state the holding members 5 laterally engage the plurality of wafers 2.

Preferably, the longitudinal holding members 5 comprise a brush and/or elastic elements allowing a careful handling.

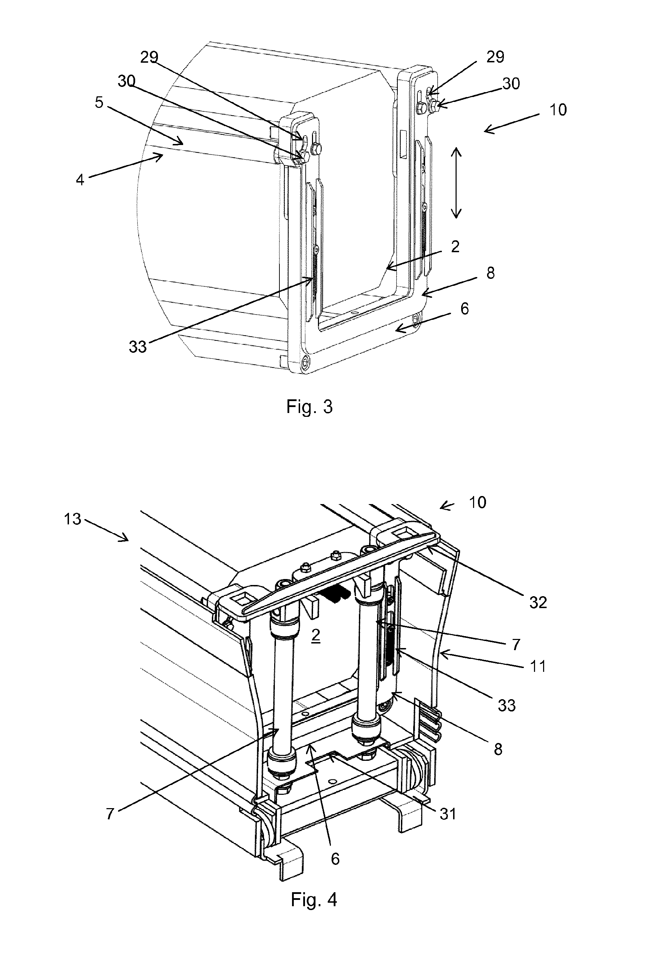

Fig. 3 now shows the front side of the wafer interacting part 10. The holding mechanism 4 comprises a guidance element 8 which is movably mounted on the base 6 of the wafer interacting part 10 and cooperates with the ends of the longitudinal holding members 5. Holding members 5 are movably mounted to the base 6 and guided in a guide 29 of the guidance element 8, the guide 29 being a slit. A pin 30 of the holding member 5 projects through the guide 29. A movement of the guidance element 8 relative to the base 6 in upward/downward direction (indicated by the double arrow) brings the holding members 5 into the release state and/or the holding state.

Fig. 4 shows the wafer interacting part 10 being inserted in the wafer receiving part 11 (front portion removed/not shown to give insight into the wafer receiving part).

The wafer receiving part 11 comprises in the area of its front face (not shown) actuators 7, which cooperate with the wafer interacting means (in the present embodiment the holding mechanism 4) of the wafer interacting part 10 in the inserted state of the wafer interacting part 10. The actuator 7 acts upon a holding mechanism 4 as to bring the holding mechanism 4 into the release state and/or into the holding state.

The actuator 7 of Fig. 4 is a pneumatic muscle which is contracted when pressure is applied to it. However, other actuators such as cylinder-piston-units, linear motors, electromagnetic drives, etc. may be used as well.

As can be seen from Fig. 4, the actuators 7 connect a movable plate 31 arranged in the bottom region of the wafer receiving part 11. A movable bar 32 being arranged in the top region of the wafer receiving part 11. The base 6 rests on the plate 31. The bar 32 (stop element) fixes the guidance element 8 of the wafer interacting part 10 relative to the walls of the wafer receiving part 11.

An actuation of the actuators 7 causes the plate 31 and thus the base 6 of the wafer interacting part 10 to be lifted relative to the guidance element 8 which in the inserted state of the wafer interacting part 10 is fixed relative to the wafer receiving part 11 by the bar 32. The actuators 7 just changes the vertical distance between plate 31 and bar 32.

Generally this principle may be described as follows: The wafer receiving part consist of two parts that are movable relative to each other e.g. by pneumatic muscles: If pressure is applied to these tubes, they blow up and become shorter. The guidance element 8 is prevented from being lifted by means attached to the wafer receiving part 11 (e.g. a mechanical stop). The guidance element 8 therefore moves downward relative to the base 6, thus forcing the pin 29 thru the slit guide 30.

The holding mechanism 4 shown in Fig. 3 and 4 is a bi-stable mechanism, the release state being a stable state and the holding state being a stable state. The holding mechanism 4 has two stable positions: one where the wafers 2 are free to enter the wafer interacting part and one where the holding members 5 engage the wafers 2. In this way, the wafer interacting part may be transported or removed from the wafer receiving part without the holding mechanism 4 losing grip on the wafers 2 or engaging on them in a undefined manner. The actuators 7 (that may be part of a processing station or of the wafer receiving part) for activating the holding mechanism 4 are then no longer needed. Also means for driving the actuators such as a power supply or supply of pressurized gas (not shown) are no longer needed.

The springs 33 connecting the guidance element 8 with the base 6 make sure that the holding mechanism 4 remains in its open position for receiving the wafers 2. Since at this point there are no wafers to press the holding members 5 aside, the guidance element would otherwise move down, moving the pin into the upper dead end. The bi-stability is reached by a bend of the guide 30. In the holding state the wafers 2 press against the holding members 5 forcing them in the upper curvature of the guide 30. Without an action of the actuators 7 a movement into the releasing state is then prevented. The bi-stability is thus only given in two different situations: when no wafers are present, the spring keeps the guidance element in the first stable position, when wafers are present, the wafers keep the guidance element in the second stable position.

In the embodiment of Fig. 4 the holding members 5 can be moved toward the wafers 2 by moving the pin 30 in the slit guide 29. When the guidance element 8 (or closing plate) is moved downward, the pin (starting at the lower dead-end) follows the slit, thus moving the holding members in inward direction. Once the pin has moved past the curve (bend) of the slit guide 30, the wafers 2 press against the holding members 5 and thus the pin 29 outward into the upper dead-end of the slit guide 30. The springs 33 make sure that the holding members 5 remain in their open position for receiving the wafers 2. Since at this point there are no wafers 2 to press the holding bars aside, the guidance element 8 would move down, moving the pin 29 into the lower dead end.

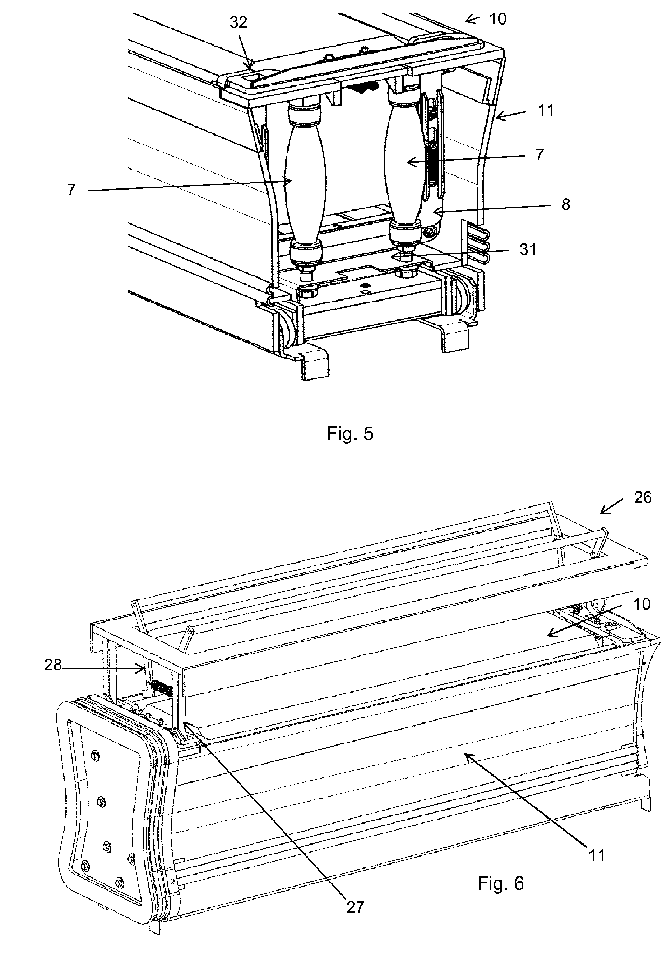

Fig. 5 shows the holding mechanism 4 in the holding state.

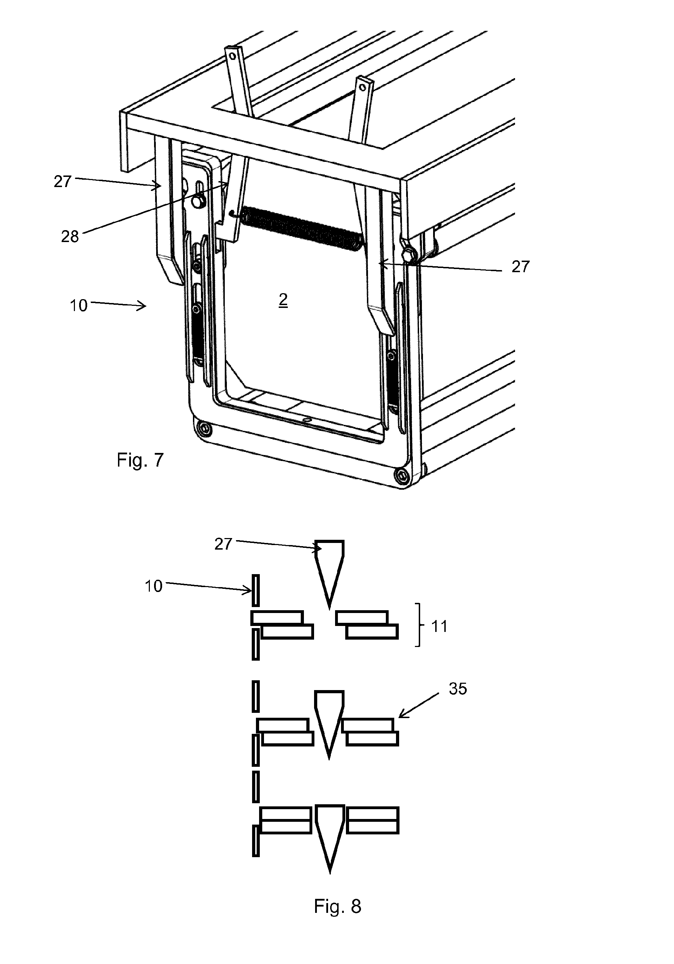

Fig. 6 and 7 show a wafer handling system 1 with a lifting device 26 for engaging and removing the wafer interacting part 10 from the wafer receiving part 11. The lifting device 26 has a de-locking means 27 for de-locking a locking mechanism between holding part 10 and wafer receiving part 11 and four gripper arms 28 for gripping the wafer interacting part 10. The de-locking means 27 is formed by straight bars the end of which cooperating with the locking mechanism between wafer interacting part 10 and wafer receiving part 11. The gripper arm 28 is a pivotable lever. The de-locking means 27 and the gripper arms 28 are arranged on the edges of a rectangle. Fig. 8 shows a locking mechanism 34 locking the wafer interacting part 10 (actually the guidance element 8) to the wafer receiving part 11 in more detail. The locking mechanism 34 may comprise movable bars 35 which may be brought into the de-locking position by a (vertical) movement the de-locking means 27.

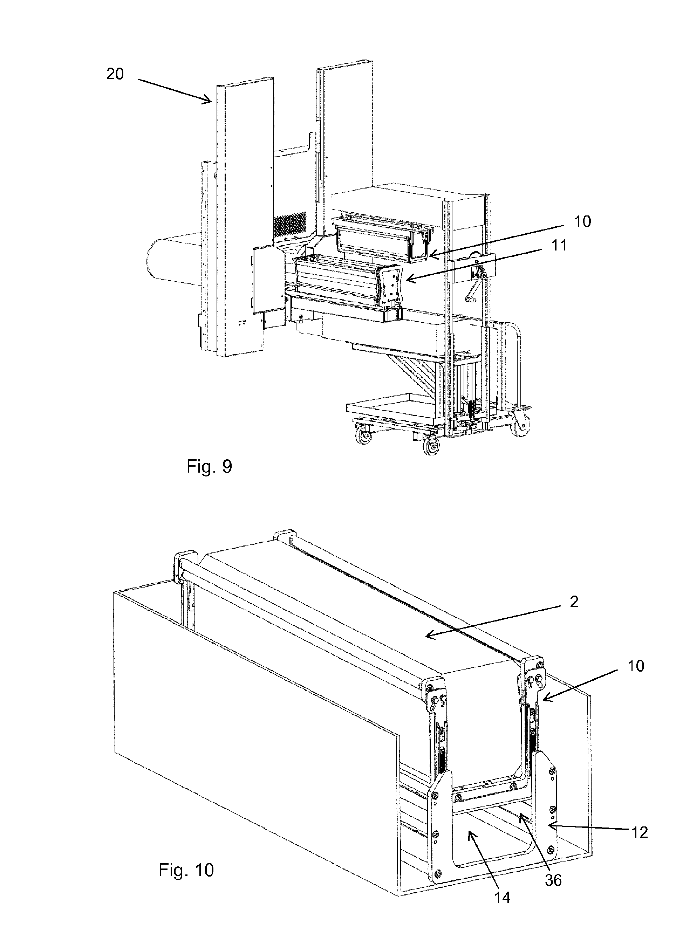

Fig. 9 shows a wire saw 20 in cooperation with an wafer handling system 1 according to the invention. The wafer receiving part is located on a "drawer" of the wire saw 20, e.g. with a (telescopic) rail guidance. This allows the handling to become more convenient, since the step of removing the wafers 2 from the wafer receiving part 11 can be performed outside the wire saw 2 and no alignment is needed when inserting the wafer receiving part 11 back into the wire saw 20. The wafer interacting means 10 holding the plurality of wafers 2 is removed vertically by means of a lifting device. Since a second wafer receiving part is positioned below the wafer interacting part, fluid dripping of the wafers 2 will be collected.

Fig. 10 shows an embodiment of a second wafer receiving part 12. In contrast to the container-like wafer receiving part 11 of Fig. 1 and 4, the wafer receiving part 12 is built up form a framework and has wafer interacting means in form of a holding mechanism 36. In Fig. 10 the wafer interacting part 10 transfers the wafers 2 to the wafer receiving part 12. During the whole transfer the wafers are securely held by the holding members 5. When the holding mechanism 36 of the wafer receiving part 12 engages the wafers 2, the holding mechanism 4 of the wafer interacting part 10 may be released (or vice versa). The transfer may be performed in a fluid bath 37.

Fig. 11 shows a wafer production line comprising several wafer processing stations. The transport from one station to another station is performed by the use of one wafer interacting part 10. In the wire saw 20 the wafer interacting part 10 may be inserted in a first wafer receiving part 11. After transferring the plurality of wafers 2 by means of the wafer interacting part 10 to a further wafer processing station, e.g. pre-cleaning station 21, the wafer interacting part 10 holding the wafers 2 is inserted into the second wafer receiving part 12 for further processing. This procedure can be repeated for the following processing steps. If desired, it is also possible to change the wafer interacting part 10 at any of the wafer processing stations.

The wafer production line of Fig. 11 comprises a wire saw 20, a wafer pre-cleaning station 21, a wafer cleaning station 22, a wafer de-gluing station 23 for de-gluing the wafers 2 from the beam 3 or removing glue from the wafers 2, a wafer separating station 24, a wafer texturization station 25 for texturizing the surface of the wafers 2. The wafer receiving parts 11, 12 may be integral part of that wafer processing station. Alternatively they may be removable from the stations and also used for transport and/or storage purposes.

In this embodiment the system 1 comprises at least two wafer receiving parts 11, 12 for receiving the plurality of wafers 2, and wherein the wafer interacting part 10 and the first wafer receiving part 11 are insertable into one another, and wherein the wafer interacting part 10 and the second wafer receiving part 12 are insertable into one another. The first wafer receiving part 11 and the second wafer receiving part 12 may have different functionality in order to comply with the requirements of different wafer processing stations.

With respect to Fig. 11 the wafer handling method for handling a plurality of essentially parallel aligned wafers 2 is described, the method comprising the steps of:
- holding the plurality of wafers 2 in a first wafer processing station, e.g. the wire saw 20, by means of the wafer interacting part 10 during and/or subsequent to a first processing step, e.g. cutting step, the wafer interacting part 10 and a first wafer receiving part 11 being inserted into one another,
- removing the wafer interacting part 10 together with the plurality of wafers 2 from the first wafer receiving part 11,
- moving the wafer interacting part 10 holding the plurality of wafers 2 to a second wafer processing station, e.g. the pre-cleaning station 21,
- inserting the wafer interacting part 10 and a second wafer receiving part 12 into one another, prior or subsequent to the step of moving the wafer interacting part 10 holding the plurality of wafers 2 to a second wafer processing station,
- performing in the second wafer processing station a second wafer processing step, e.g. pre-cleaning.

In Fig. 13 an embodiment of the wafer receiving part 12 is shown with a fluid application means 37, e.g. in form of at least one nozzle or at least one fluid inlet. The fluid application means 37 is preferably accommodated in laterally extending portions of the wafer receiving part 12. The fluid application means 37 is also understood as wafer interacting means, since it wets the wafers 2 and/or directs fluid (e.g. cleaning fluid, cutting fluid and/or de-gluing fluid) onto the wafers 2 and thus indirectly interacts with the wafers 2.

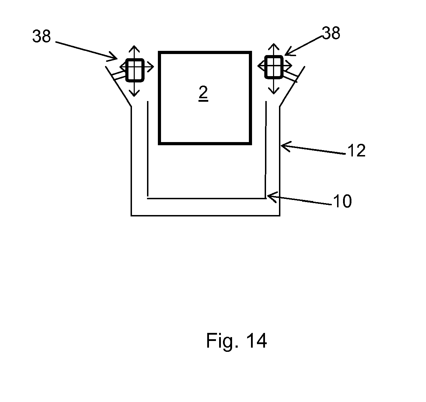

Alternatively, the wafer interacting means may be a displacing mechanism 38 for displacing the wafers 2 relative to walls of the wafer receiving part 12 (Fig. 14). As can be seen from Fig. 14 the holding members of the displacing mechanism 38 mechanically engaging the wafers 2 may be movable in lateral directions and/or in vertical direction, such that the wafers 2 can be moved within the wafer receiving part 12. The displacing mechanism 38 is preferably accommodated in laterally extending portions of the wafer receiving part 12. The displacing mechanism 38 may be provided additionally to a holding mechanism and may be used to release the wafers 2 from the beam 3.

Generally, the wafer interacting means may be selected from the group consisting of a holding mechanism for holding the wafers 2, a detaching means for detaching the wafers 2 from the beam 3, a fluid application means for applying a fluid to the wafers 2 and/or to the beam 3, fluid flow generating means for generating a fluid flow, and a displacing mechanism for displacing the wafers 2 relative to the walls of the at least one wafer receiving part 11, 12, an energy source for transferring energy to the wafers 2, e.g. a heat source or an electromagnetic radiation source.

Finally, it has to be mentioned that an embodiment is possible in which the parts are dimensioned such that the wafer receiving part is insertable into the wafer interacting part. The wafer interacting means of the wafer interacting part may act upon the wafers e.g. through openings, holes, slits, etc. in the wall of the wafer receiving part.

The invention is not restricted to these embodiments. Other variants will be obvious for the person skilled in the art and are considered to lie within the scope of the invention as formulated in the following claims.

### List of reference marks

- 1: wafer handling system
- 2: wafer
- 3: beam
- 4: holding mechanism
- 5: holding member
- 6: base of the wafer interacting part 10
- 7: actuator
- 8: guidance element
- 9: ingot
- 10: wafer interacting part
- 11: first wafer receiving part
- 12: second wafer receiving part
- 13: opening of the first wafer receiving part 11
- 14: opening of the second wafer receiving part 12
- 15: wafer receiving volume
- 16: support base
- 17: wire guide roller
- 18: wire web
- 19: fixture attachment
- 20: wire saw
- 21: wafer pre-cleaning station
- 22: wafer cleaning station
- 23: wafer de-gluing station
- 24: wafer separation station
- 25: wafer texturization station
- 26: lifting device
- 27: de-locking means
- 28: gripper
- 29: guide
- 30: pin
- 31: plate
- 32: bar
- 33: spring
- 34: locking mechanism
- 35: movable bars
- 36: holding mechanism
- 37: fluid application means
- 38: displacing mechanism

## Claims

1. Wafer handling system (1) for handling a plurality of essentially parallel aligned wafers (2), the system comprising:
- a wafer interacting part (10) comprising wafer interacting means for acting upon the plurality of wafers (2), and
- at least one wafer receiving part (11, 12) for receiving the plurality of wafers (2),
**characterized in that**
the wafer interacting part (10) and the at least one wafer receiving part (11, 12) are dimensioned relative to each other such that one of the wafer interacting part (10) and the wafer receiving part (11, 12) may inserted into the other of the wafer interacting part (10) and the wafer receiving part (11, 12).

2. Wafer handling system according to claim 1, **wherein** the wafer handling system (1) comprises at least two wafer receiving parts (11, 12) for receiving the plurality of wafers (2), and wherein the wafer interacting part (10) and the first wafer receiving part (11) are insertable into one another, and wherein the wafer interacting part (10) and the second wafer receiving part (12) are insertable into one another, wherein preferably the first wafer receiving part (11) and the second wafer receiving part (12) have different functionality.

3. Wafer handling system according to claim 1 or 2, **wherein** the wafer interacting part (10) may be inserted into the at least one wafer receiving part (11, 12).

4. Wafer handling system according to one of the preceding claims, **wherein** the at least one of the wafer receiving part (11, 12) and the wafer interacting part (10) has on its upper side an opening (13, 14) adapted for receiving the plurality of wafers (2).

5. Wafer handling system according to one of the preceding claims, **wherein** the at least one wafer receiving part (11, 12) is a container enclosing a wafer receiving volume (15), wherein preferably the container is a fluid reservoir adapted to contain fluid in the wafer receiving volume (15).

6. Wafer handling system according to one of the preceding claims, **wherein** the at least one wafer receiving part (11) is integral part of a wafer processing station (20, 21, 22, 23, 24, 25), wherein preferably the wafer processing station is selected from the group consisting of a wire saw (20), a wafer pre-cleaning station (21), a wafer cleaning station (22), a wafer de-gluing station (23) for de-gluing the wafers (2) from the beam (3) or removing glue from the wafers (2), a wafer separating station (24), a wafer texturization station (25) for texturizing the surface of the wafers (2) or any combination thereof.

7. Wafer handling system according to one of the preceding claims, **wherein** the wafer interacting means of the wafer interacting part (10) comprises a holding mechanism (4) for holding the plurality of wafers (2), wherein preferably the holding mechanism (4) may be set in a releasing state and in a holding state.

8. Wafer handling system according to one of the preceding claims, **wherein** the wafer interacting part (10) comprises a base (6) to which the wafer interacting means is mounted, the base defining the position of the wafer interacting means relative to the wafer receiving part (11, 12) when the wafer interacting part (10) and the wafer receiving part (11, 12) are inserted into one another, wherein preferably the base (6) is built from a framework, wherein preferably the framework has the contour of a cuboid.

9. Wafer handling system according to one of the claims 7 to 8, **wherein** the holding mechanism (4) of the wafer interacting part (10) comprises holding members (5), wherein at least one holding member (5) is movable towards the plurality of wafers (2) when being received by the wafer interacting part (10), and wherein preferably the holding members (5) are movable from opposite sides towards the plurality of wafers (2), and wherein preferably the holding members (5) comprise a brush and/or elastic elements.

10. Wafer handling system according to one of the preceding claims, **wherein** the at least one wafer receiving part (11, 12) comprises at least one actuator (7), which cooperates with the wafer interacting means of the wafer interacting part (10) when the wafer interacting part (10) and the wafer receiving part (11, 12) are inserted into one another, wherein preferably the actuator acts upon a holding mechanism (4) as to bring the holding mechanism (4) into the release state and/or into the holding state, and/or wherein preferably the actuator (7) is a pneumatic muscle which is contracted when pressure is applied to it.

11. Wafer handling system according to one of the claims 9 to 10, **wherein** the holding mechanism (4) comprises a guidance element (8) which is movably mounted on the base (6) of the wafer interacting part (10) and cooperates with the holding members (5) wherein a movement of the guidance element (8) relative to the base (6) brings the holding members (5) into the release state and/or the holding state.

12. Wafer handling system according to claim 11, **wherein** an actuation of the actuator (7) causes the base (6) of the wafer interacting part (10) to be lifted relative to the guidance element (8) which in the inserted state of the wafer interacting part (10) and the at least one wafer receiving part (11, 12) is fixed relative to the wafer receiving part (11, 12).

13. Wafer handling system according to one of the claims 7 to 13, **wherein** the holding mechanism (4) is at least a bi-stable mechanism, the release state being a stable state and the holding state being a stable state.

14. Wafer handling system according to one of the preceding claims, **wherein** the at least one wafer receiving part (11, 12) comprises wafer interacting means for acting upon the plurality of wafers (2) when being received in the wafer receiving part (11, 12), wherein preferably the wafer interacting means is selected from the group consisting of a holding mechanism for holding the wafers (2), a detaching means for detaching the wafers (2) from the beam (3), a fluid application means (37) for applying a fluid to the wafers (2) and/or to the beam (3), fluid flow generating means for generating a fluid flow, and a displacing mechanism (38) for displacing the wafers (2) relative to the walls of the at least one wafer receiving part (11, 12), an energy source for transferring energy to the wafers (2), e.g. a heat source or an electromagnetic radiation source.

15. Wafer handling method for handling a plurality of essentially parallel aligned wafers (2) with a wafer handling system according to any of the preceding claims, the method comprising the steps of:
- holding the plurality of wafers (2) in a first wafer processing station by means of the wafer interacting part (10) during and/or subsequent to a first processing step, the wafer interacting part (10) and a first wafer receiving part (11) being inserted into one another,
- removing the wafer interacting part (10) together with the plurality of wafers (2) from the first wafer receiving part (11),
- moving the wafer interacting part (10) holding the plurality of wafers (2) to a second wafer processing station,
- inserting the wafer interacting part (10) and a second wafer receiving part (12) into one another, prior or subsequent to the step of moving the wafer interacting part (10) holding the plurality of wafers (2) to a second wafer processing station,
- performing in the second wafer processing station a second wafer processing step.
